# DEMANDE DE BREVET EUROPEEN

(11) **EP 2 584 617 A1**
(43) Date de publication de la demande: **24.04.2013**
(21) Numéro de dépôt: 12188903.4
(22) Date de dépôt: 17.10.2012
(51) Int. Cl.: H01L 33/46, H01L 33/50

(54) **Composant diode électroluminescente**

(30) Priorité: 18.10.2011 FR 1159383
(71) Demandeur: COMMISSARIAT A L'ENERGIE ATOMIQUE ET AUX ENERGIES ALTERNATIVES, 75015 Paris (FR)
(72) Inventeur: Gasse, Adrien, 38100 Grenoble (FR); Desieres, Yohan, 38250 Lans En Vercors (FR); Levy, François, 38640 Claix (FR)
(74) Mandataire: Hautier, Nicolas

(57) **Abrégé**

Un composant diode électroluminescente est décrit qui comporte : une source primaire (1); une couche de conversion (3) formant une source secondaire configurée pour absorber en partie au moins le rayonnement primaire et émettre un rayonnement secondaire; une couche d'encapsulation (2), située entre les sources primaire et secondaire. Le composant diode électroluminescente comprend également une couche de réflexion (i) située entre la couche d'encapsulation (2) et la couche de conversion (3) et présentant une face au contact de la couche d'encapsulation (2) de manière à former une interface avec la couche d'encapsulation (2); la couche de réflexion (i) et la couche d'encapsulation (2) étant configurées de manière à ce que ladite interface laisse passer le rayonnement primaire issu de la source primaire et réfléchisse le rayonnement secondaire vers l'extérieur de la diode électroluminescente.

L'invention comprend également un système comportant une composant diode électroluminescente et un procédé de fabrication d'un tel composant.

## Description

### DOMAINE TECHNIQUE DE L'INVENTION

La présente invention concerne les diodes électroluminescentes en général et plus particulièrement celles qui sont conçues pour émettre une lumière à partir d'une source primaire et d'une source secondaire qui absorbe une partie du rayonnement de la source primaire et qui réémet son propre rayonnement. La présente application reçoit par exemple pour application les diodes électroluminescentes émettant une lumière blanche.

### ÉTAT DE LA TECHNIQUE

Les diodes électroluminescentes, ou LED, acronyme de l'anglais « light-emitting diode » produites depuis les années soixante par l'industrie de la microélectronique ont vu leur champ d'application s'élargir au fil des années. L'éclairage, en remplacement des lampes à incandescence, et des applications plus sophistiquées comme le rétro éclairage d'afficheurs à cristaux liquides, font maintenant partie du champ d'application des LEDs. Ces applications demandent de pouvoir disposer de LEDs blanches. Du fait même du principe physique de fonctionnement des LEDs, il n'existe cependant pas de diode unique capable d'émettre dans tout le spectre des longueurs d'ondes visibles, c'est-à-dire, environ, entre 400 et 800 nanomètres (nanomètre ou nm = 10⁻⁹ mètre).

Une technique largement employée pour produire une lumière blanche consiste à utiliser une LED, habituellement désignée « puce LED », émettant dans une partie du spectre, la puce LED étant incorporée au sein d'un composant habituellement désigné « composant LED » ou « composant diode électroluminescent ». La puce LED constitue une source primaire de photons qui sont en partie transmis et en partie absorbés par un matériau luminescent incorporé dans le composant LED à proximité de la source primaire. Le matériau luminescent, qui constitue une source secondaire de photons, réémet de la lumière dans une gamme de longueurs d'ondes plus grande. Le tout est perçu comme une lumière blanche par l'oeil humain.

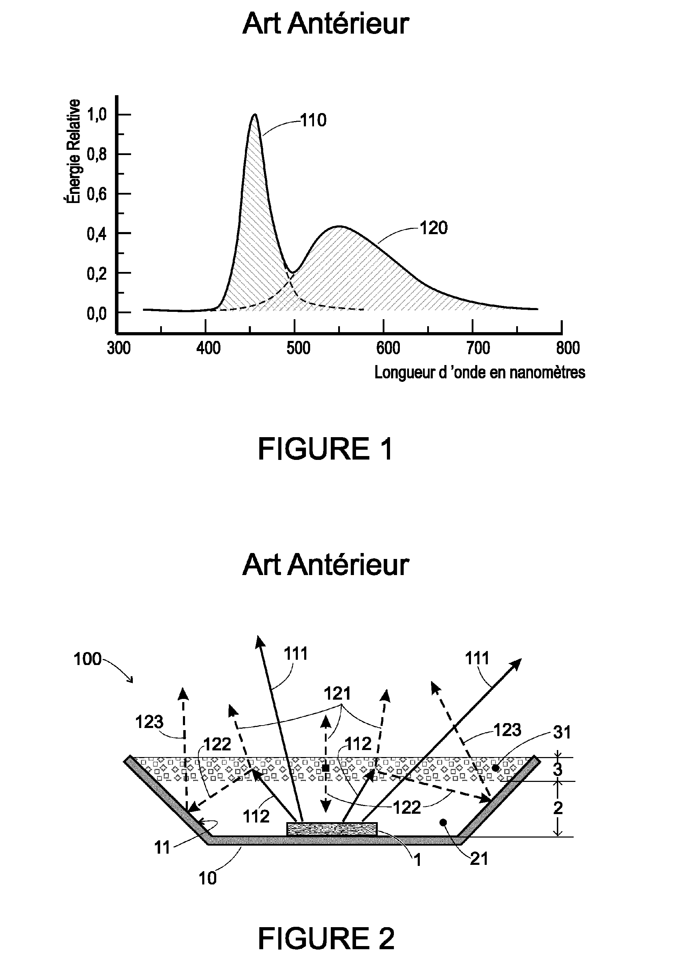

Depuis que l'on sait faire des LEDs émettant dans le bleu, la source primaire est le plus souvent une puce LED dont le semi-conducteur est du nitrure de gallium (GaN) émettant dans une gamme de longueurs d'ondes de l'ordre de 450 nanomètres. La source secondaire est choisie pour émettre dans le jaune. Le matériau luminescent est typiquement du YAG:Ce, acronyme de l'anglais « Yttrium Aluminium Garnet » désignant le « grenat d'yttrium et d'aluminium » dopé au cérium (Ce). Comme montré sur la figure 1, le rayonnement 110 provenant de la source primaire bleue et le rayonnement 120 provenant de la source secondaire jaune, couleur complémentaire du bleu, se combinent pour donner une lumière qui apparaît alors comme blanche à l'oeil humain.

Le YAG est généralement disponible sous forme de poudre qui est mélangée à une matrice organique polymère de type époxy ou silicone, ou encore à un matériau inorganique comme le verre. Le YAG constitue alors des luminophores inclus dans le matériau enrobant. La figure 2 illustre une structure classique de composant LED 100 blanche fonctionnant selon les principes exposés brièvement ci-dessus. Dans cet exemple particulier de mise en oeuvre, les luminophores 31 sont déportés dans une couche 3 située à distance de la source primaire, la puce LED bleue 1, qui est à cet effet enrobée dans une couche 2 d'un matériau encapsulant 21. La couche 3 est désignée couche de conversion.

Dans une telle structure, une partie 111 du rayonnement émis par la source primaire est transmise directement. L'autre partie 112 est absorbée par les luminophores 31 qui réémettent un rayonnement secondaire. Dans la structure telle que celle illustrée en figure 2, où les luminophores sont déportés, la moitié 121 du rayonnement converti est alors effectivement réémise directement vers l'extérieur du dispositif. L'autre moitié 122 est réémise vers l'intérieur. Une partie 123 du rayonnement secondaire réémis vers l'intérieur 122, va cependant aussi pouvoir contribuer à la lumière blanche émise en étant renvoyée vers l'extérieur par les parois internes réfléchissantes 11 du support 10 formant un boîtier et ainsi améliorer l'efficacité lumineuse du dispositif. L'amélioration est d'autant plus importante que la surface des parois réfléchissante est grande devant celle de la puce LED 1. Une grande distance entre les luminophores 31 et la puce permet également d'améliorer l'efficacité lumineuse. Cependant, dans la mesure où on cherche en même temps à diminuer la taille des boîtiers, l'amélioration obtenue en terme d'efficacité est en général assez faible, au mieux elle est de l'ordre de 15 % typiquement.

La réflexion vers l'extérieur du rayonnement secondaire est donc loin d'être totale ce qui ne permet pas d'atteindre l'efficacité lumineuse optimale d'un tel dispositif. Le rayonnement secondaire qui reste confiné dans le dispositif contribue aussi significativement à son échauffement ce qui est préjudiciable à la durée de vie du dispositif et à son fonctionnement. Notamment, les puces LEDs les plus puissantes doivent avoir recours à des dissipateurs thermiques importants pour maintenir leur température de jonction à un niveau où la conversion électrique optique se fait avec le meilleur rendement possible.

De nombreuses améliorations ont été proposées pour ce type de composants LEDs qui délivre une lumière blanche en utilisant une couche de conversion contenant un matériau luminescent. En général elles compliquent cependant sérieusement le procédé de fabrication. Par exemple, dans la demande de brevet intitulée « Encapsulation for phosphor-converted white light emitting diode » et publiée sous le numéro US 2009/0272996 il est indiqué que l'extraction de lumière est grandement améliorée en utilisant des nano particules qui sont introduites dans la couche de conversion afin d'en ajuster l'indice de réfraction. Une couche d'espacement entre source primaire et secondaire est aussi décrite qui participe à l'obtention d'une meilleure extraction de la lumière produite notamment depuis la source secondaire mais qui n'est pas fondamentalement différente de la couche 2 décrite ci-dessus. La formation et l'introduction des nano particules dans la couche de conversion demande cependant d'avoir recours à une technologie sophistiquée qui s'accommode mal avec une production de masse, à bas coût, de telles LED blanches.

Un autre exemple d'amélioration obtenue est décrit dans une publication intitulée « Enhanced forward efficiency of Y3Al5O12:Ce3+ phosphor from white light-emitting diodes using blue-pass yellow-reflection filter », publiée le 27 avril 2009 dans « OPTICS EXPRESS », Volume 17, Numéro 9, par Jeong Rok Oh et coauteurs, université Kookmin, département de chimie, Séoul 136-702, Corée du Sud. Cette publication fait état de l'utilisation de filtres optiques, placés entre la source primaire émettant dans le bleu et la source secondaire émettant dans le jaune, et destinés à réfléchir la lumière jaune tout en laissant passer la lumière bleue afin d'améliorer l'efficacité d'extraction de la lumière. La mise en oeuvre des filtres qui consistent en un empilement de nombreuses couches d'oxyde de silicium (SiO2) et de titane (TiO2) dont les épaisseurs doivent être soigneusement contrôlées afin de produire les interférences lumineuses recherchées pour la fonction de filtrage, est pour le moins difficile. Là aussi, il faut mettre en place un procédé de fabrication complexe qui est incompatible avec une production de dispositifs à faible coût.

C'est donc un objet de l'invention que de décrire un procédé de fabrication simple à mettre en oeuvre et qui permet cependant d'améliorer significativement l'efficacité d'extraction de la lumière d'un composant LED comprenant une couche de conversion contenant un matériau luminescent.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Un aspect de la présente invention concerne un composant à diode électroluminescente (composant LED) comportant : au moins une source primaire configurée pour émettre un rayonnement primaire lorsqu'elle est activée électriquement ; au moins une couche de conversion formant une source secondaire configurée pour absorber au moins en partie le rayonnement primaire et émettre un rayonnement secondaire ; au moins une couche d'encapsulation qui est située au contact de la source primaire et qui est configurée pour laisser passer le rayonnement primaire. Le composant comportant également au moins une couche de réflexion située entre la couche d'encapsulation et la couche de conversion et présentant une face au contact de la couche d'encapsulation de manière à former une interface avec la couche d'encapsulation; la couche de réflexion et la couche d'encapsulation étant configurées pour que ladite interface soit conformée pour laisser passer le rayonnement primaire et pour réfléchir vers l'extérieur du composant diode électroluminescente tout le rayonnement secondaire émis par la couche de conversion et qui atteint ladite interface en formant, avec une perpendiculaire à ladite interface, un angle supérieur à l'angle limite Arcsin(n₂/nᵢ), n₂ et nᵢ étant les indices de réfraction respectifs de la couche d'encapsulation et de la couche de réflexion. Tous les faisceaux du rayonnement secondaire qui atteignent l'interface avec un angle supérieur à cet angle limite sont donc réfléchis par réflexion totale.

La combinaison de la couche d'encapsulation et de la couche de réflexion permet ainsi de former une interface capable d'extraire hors de la diode électroluminescente tout ou partie du rayonnement secondaire se propageant en direction de la source primaire ou de l'intérieur du composant LED. Le rayonnement secondaire bloqué et réfléchi vers l'extérieur par ladite interface provient de la source secondaire soit directement, soit par réflexion.

Dans le cadre de la présente invention, il a été identifié que dans les composants LED existants, la rugosité de la couche de conversion formant la source secondaire, lorsque cette couche est au contact d'une couche d'encapsulation ou d'espacement disposée au contact des sources primaire et secondaire, limite l'extraction du rayonnement hors du composant LED. Du fait de cette rugosité de la couche de conversion, une partie du rayonnement réémis par cette source secondaire pénètre donc vers l'intérieur du composant LED. Cette rugosité est pour l'essentiel due à la taille des particules de matériau luminophore présentes dans la couche de conversion. Pour réduire la rugosité de cette couche il faudrait en particulier réduire la taille des particules, en les remplaçant par exemple par des nano particules luminophores. Dans le cadre de la présente invention, il s'est avéré que cette modification de la couche de conversion induit pour le composant LED une complexité d'obtention et un coût accrus.

L'invention, en créant une nouvelle interface décorrélée de la couche de conversion formant la source secondaire, permet ainsi d'obtenir une extraction améliorée sans avoir à réduire la rugosité de cette couche de conversion.

Le rendement de la diode est par conséquent amélioré sans que l'on ait besoin de contrôler précisément la rugosité de la couche de conversion formant la source secondaire.

L'invention permet également de lever les fortes contraintes sur les épaisseurs des différentes couches, ces contraintes étant inévitables dans les solutions basées sur les effets d'interférence.

L'invention permet ainsi de produire plus aisément et à moindre coût des composants LEDs à rendement élevé.

De manière facultative, l'invention peut en outre présenter au moins l'une quelconque des caractéristiques optionnelles suivantes :
- Ladite face de la couche de réflexion présente une rugosité Ra inférieure à 50 nm et de préférence inférieure à 5 nm. La rugosité Ra est définie comme l'écart moyen arithmétique. Elle est classiquement mesurée au moyen d'un microscope à force atomique (AFM) par exemple.
- L'indice de réfraction ni de la couche de réflexion est supérieur à l'indice n2 de la couche d'encapsulation. De préférence, la couche de réflexion et la couche d'encapsulation sont configurées de sorte que ni/n2 > 1.2. Encore plus préférentiellement, la couche de réflexion et la couche d'encapsulation sont configurées de sorte que ni/n2 > 1.4.

En jouant uniquement sur les caractéristiques (indices de réfraction et rugosité en particulier) de la couche intermédiaire et de la couche d'encapsulation, on peut ainsi obtenir un comportement de réflexion spéculaire ou quasiment spéculaire à ladite interface. L'extraction du rayonnement hors de la diode est par conséquent optimisé et le rendement considérablement amélioré.

En outre l'invention permet d'obtenir une forte extraction tout en limitant les dimensions du composant LED. En effet, l'invention ne nécessite pas d'éloigner fortement la source secondaire de la source primaire.
- La couche de conversion formant une source secondaire et la couche de réflexion sont configurées de sorte que l'indice de réfraction n₃ de la couche de conversion soit supérieur à l'indice de réfraction nᵢ de la couche de réflexion.
- Préférentiellement, la couche de réflexion est disposée au contact de la source secondaire. Le composant diode électroluminescent comporte donc une unique couche de réflexion. Il n'y a qu'une seule couche entre la couche d'encapsulation et la source secondaire. Le procédé de réalisation est ainsi simplifié. La qualité de l'interface est mieux maîtrisé et est rendu plus fiable.
- La couche de réflexion est sensiblement transparente au rayonnement primaire. De préférence, la couche de réflexion a un comportement optiquement homogène. Elle peut être soit monolithique, c'est-à-dire formée d'un unique matériau, soit formée d'un empilement de matériaux d'indices optiques égaux.
- La couche d'encapsulation est disposée au contact de la source primaire.
- Avantageusement, la couche d'encapsulation est conformée pour mettre en forme le faisceau formé par le rayonnement émis par la source primaire. Par exemple, la couche d'encapsulation peut avoir une forme hémisphérique.
- De préférence, la couche de réflexion est en un matériau comprenant au moins l'un des matériaux pris parmi: le sulfure de zinc (ZnS), l'oxyde de zinc (ZnO), l'oxyde de titane (TiO₂), l'oxyde d'étain et d'indium (ITO), l'oxyde d'indium (In₂0₃), l'oxyde de zirconium (ZrO₂), l'oxyde de hafnium (HfO₂), le nitrure de silicium (Si₃N₄) et l'oxyde de tantale (Ta₂O₅). De préférence, la couche d'encapsulation est en un matériau comprenant au moins l'un des matériaux pris parmi : un polymère organique de type silicone, époxy ou acrylique, un matériau inorganique comme du verre. De préférence, la source primaire comprend une puce comprenant un matériau pris parmi : le nitrure de gallium (GaN), le nitrure d'indium et de gallium (InGaN), le nitrure d'aluminium (AlN), le nitrure d'aluminium et de Gallium (AlGaN), ou InAlGaN, l'oxyde de zinc (ZnO), GaP, GaAsP, InGaAlP.
- La couche d'encapsulation est au contact de la puce LED. Elle entoure cette dernière en partie au moins.

Selon un mode de réalisation, la puce LED est disposée sur un support tel qu'un boîtier par exemple et le matériau formant la couche d'encapsulation est par exemple versé sur la puce LED de sorte à l'encapsuler.

Selon un autre mode de réalisation, la puce LED est disposée sur un support. Le matériau formant la couche d'encapsulation est quant à lui déposé sur un empilement de couches comprenant la couche de conversion et la couche de réflexion. La puce LED et son support sont alors rapportés sur l'empilement de sorte à plonger la puce LED dans la couche d'encapsulation.
- Une seule interface est prévue pour assurer la réflexion du rayonnement secondaire. De préférence, au moins 70% du rayonnement secondaire est réfléchi à cette interface de réflexion unique. L'invention permet ainsi de se passer d'une structure complexe nécessitant la superposition d'un grand nombre d'interfaces formant chacune un filtre.
- La source secondaire se présente sous forme d'une couche de conversion. La source secondaire comprend, au moins en partie, un matériau luminescent.

De préférence, la couche de conversion comprend une matrice à l'intérieur de laquelle sont logées des particules du matériau luminescent. Ces particules sont désignées luminophores. Avantageusement, la matrice est en silicone, et le matériau luminescent est un grenat d'yttrium et d'aluminium dopé au cérium (YAG:Ce). Les particules ont typiquement une taille comprise entre 0,05 et 50 µm et de préférence entre 0,05 et 30 µm. De manière particulièrement avantageuse, les particules incluent ou sont des nanophosphore dons la taille est typiquement inférieure 500 nanomètres voire inférieures à 100 nanomètres. De préférence, la matrice présente un indice de réfraction nm tel que nₘ>=n₂.

Alternativement, la source secondaire forme une couche homogène optiquement.

La source secondaire forme une couche dont l'indice de réfraction n₃ est tel que n₃>n₂.

Le composant LED comprend un empilement de couches superposées. La couche d'encapsulation surmonte la puce LED, la couche de réflexion surmonte la couche d'encapsulation et la couche de conversion surmonte la couche de réflexion. Avantageusement, l'épaisseur e₂ de la couche d'encapsulation, l'épaisseur eᵢ de la couche de réflexion et l'épaisseur e₃ de la couche de conversion sont telles que e₂>λ/n₂, eᵢ>λ/nᵢ, e₃>λ/n₃, n₂, nᵢ et n₃ étant respectivement les indices de réfraction de la couche d'encapsulation, de la couche de réflexion et de la couche de conversion et λ étant la longueur d'onde la plus élevée de la gamme d'ondes du rayonnement émis par le composant.
- Avantageusement, l'épaisseur de la couche d'encapsulation est comprise entre 0,5 µm et 5 mm et de préférence d'environ 375 µm. Préférentiellement, pour obtenir des propriétés d'anti-reflet à partir de la couche d'encapsulation sur l'interface avec la source primaire, l'épaisseur de la couche d'encapsulation sera choisie tel que e₂ = λ/4n₂ + j. λ/2 ou j est un entier pouvant prendre une valeur de 0 à l'infini. L'épaisseur de la couche de réflexion est comprise entre 0, 4 µm et 5 µm et de préférence d'environ 500 nm. Ces épaisseurs sont relativement grandes et n'imposent pas de fortes contraintes dans le procédé de fabrication. En outre, elles ne requièrent pas d'être contrôlées avec une grande précision.
- De préférence, ladite interface est sensiblement plane. De préférence, la couche de réflexion est sensiblement plane.
- De préférence, la source secondaire forme une couche dont une face externe est tournée vers l'extérieure du composant LED, cette face externe présentant une rugosité supérieure à 50nm. Avantageusement, la structuration créée par la rugosité de la face externe permet d'obtenir un comportement diffusif du composant LED.

De manière alternative ou cumulée, la source secondaire forme une couche dont une face externe est tournée vers l'extérieure de la LED, et la LED comprend une lentille hémisphérique disposée entre ladite face externe et l'extérieur. Typiquement, la lentille est disposée au contact de la couche formant source secondaire. De préférence elle est en un matériau choisi parmi : le verre ou un matériau polymère organique transparent ou sensiblement transparent.
- Préférentiellement, la source primaire, la couche d'encapsulation et la couche de réflexion au moins sont logées dans une cavité. De préférence, la cavité est formée par un boîtier présentant des parois intérieures réfléchissantes, typiquement en métal ou dans un matériau polymère formant réflecteur. De préférence, la source secondaire est également logée dans le boîtier.

Selon un mode particulier de réalisation, la cavité est formée par la source secondaire. De préférence, la source primaire repose alors sur un support, typiquement une embase métallique.

Selon un mode de réalisation alternatif, la source primaire repose sur un support présentant une forme plane. Ce mode de réalisation est particulièrement simple et peu coûteux à réaliser.

Selon un mode de réalisation alternatif, la source primaire repose sur un support présentant une forme convexe. Ce mode de réalisation permet d'avoir une indicatrice d'émission supérieure à 180°.

De préférence, on prévoit pour les modes de réalisation dans lesquels le support est plan ou convexe, un moule disposé à l'intérieur duquel sont coulés les matériaux formant les différentes couches, la puce LED étant ensuite rapportée dans la couche d'encapsulation.
- De préférence, la source primaire et la source secondaire émettent chacune des rayonnements sensiblement monochromatiques. Alternativement, la source primaire et la source secondaire émettent des rayonnements dans des gammes de longueurs d'onde. Les gammes des rayonnements primaires et secondaires peuvent avoir des longueurs d'ondes communes. Alternativement, ces deux gammes ne se chevauchent pas et les rayonnements primaires et secondaires présentent des longueurs d'ondes différentes.
- De préférence, la longueur d'onde primaire émise par la source primaire est inférieure à la longueur d'onde secondaire émise par la source secondaire.

Selon un autre aspect, l'invention concerne un système d'éclairage, d'affichage ou de signalisation ou un dispositif comportant au moins un composant diode électroluminescente selon l'une quelconque des caractéristiques précédentes.

Selon un autre aspect, l'invention concerne un procédé de fabrication d'un composant diode électroluminescente, le procédé comprenant les étapes suivantes : disposer une source primaire configurée pour émettre un rayonnement primaire présentant lorsqu'elle est activée électriquement ; disposer une couche de conversion formant une source secondaire configurée pour absorber au moins en partie le rayonnement primaire et émettre un rayonnement secondaire ; disposer une couche d'encapsulation entre les sources primaire et secondaire et configurée pour laisser passer le rayonnement émis par la source primaire en direction de la source secondaire ; disposer une couche de réflexion entre la couche d'encapsulation et la couche de conversion de sorte qu'une face de la couche de réflexion soit au contact de la couche d'encapsulation pour former une interface avec la couche d'encapsulation ; choisir la couche de réflexion et la couche d'encapsulation de sorte que l'interface formée par la couche de réflexion et par la couche d'encapsulation est conformée pour laisser passer le rayonnement primaire issu de la source primaire et pour réfléchir vers l'extérieur du composant diode électroluminescent, complètement ou en partie au moins, le rayonnement secondaire.

Facultativement, le procédé comprend en outre les étapes optionnelles suivantes :
- la source primaire est fixée dans un boîtier formant une cavité ;
- Selon un premier mode de réalisation, la couche d'encapsulation et la couche de conversion sont dispensées sous forme liquide dans le boîtier. Avantageusement, la réticulation et la solidification de la couche d'encapsulation et de la couche de conversion sont obtenues thermiquement. Avantageusement, la couche de réflexion est déposée par voie chimique ou physique en phase vapeur (PVD ou CVD).
- Selon un premier mode de réalisation, les étapes de disposition de la couche de conversion, de la couche de réflexion et de la couche d'encapsulation comprennent respectivement une étape de dépôt de la couche de conversion dans un moule présentant une forme de dôme, une étape de dépôt de la couche de réflexion sur la couche de conversion, une étape de dépôt de la couche d'encapsulation sur la couche de réflexion. Avantageusement, le procédé comprenant en outre une étape de report de la puce LED dans la couche de la couche d'encapsulation. De préférence, le procédé comprend, préalablement à l'étape de report de la puce LED dans la couche de la couche d'encapsulation, une étape de fixation de la puce LED sur un support plan ou convexe.
- la couche de conversion est disposée au contact de la couche de réflexion. Le procédé comprend une étape d'augmentation de la rugosité à l'interface entre la couche de conversion et la couche de réflexion. Cette rugosité Ra est de préférence supérieure à 50 nm. Le procédé selon l'invention permet ainsi de conférer à cette interface un caractère diffusant.
- l'étape d'augmentation de la rugosité à l'interface entre la couche de conversion et la couche de réflexion comprend au moins une gravure plasma et/ou une gravure chimique.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La FIGURE 1 illustre l'art antérieur et le mode de production d'une lumière blanche à partir d'une source primaire colorée et d'une source secondaire de conversion utilisant un matériau luminescent.
La FIGURE 2 décrit une mise en oeuvre conventionnelle d'un composant LED émettant une lumière blanche et incluant une couche de conversion déportée comprenant des luminophores faits d'un matériau luminescent.
La FIGURE 3 illustre le principe de fonctionnement et la structure d'un composant LED blanche selon un exemple de réalisation de l'invention qui permet d'obtenir une meilleure extraction de la lumière produite.
Les FIGURES 4a à 4f décrivent les étapes d'un exemple de procédé de fabrication d'un composant LED selon l'invention.
La FIGURE 5 illustre la réalisation d'un composant LED selon l'invention avec un support plan.
La FIGURE 6 illustre la réalisation d'un composant LED selon l'invention avec un support convexe.

Les dessins joints sont donnés à titre d'exemples et ne sont pas limitatifs de l'invention.

### DESCRIPTION DÉTAILLÉE DE L'INVENTION

Dans la présente invention, on désigne par puce ou puce LED une source lumineuse émettant un flux primaire lorsqu'elle est activée. Une puce présente typiquement une épaisseur inférieure à quelques centaines de micromètres. On désigne par composant LED, un composant diode électroluminescent ou module LED, un ensemble 100 comportant au moins une puce LED formant une source primaire 1 (ou couche LED), une source secondaire comprenant un ou plusieurs matériaux luminescents et un boîtier ou support 10 contenant et ou sur laquelle sont reportées la(les) source primaire(s) 1 et la source secondaire. L'ensemble 100 est habituellement qualifié de puce LED ou de LED chip en anglais.

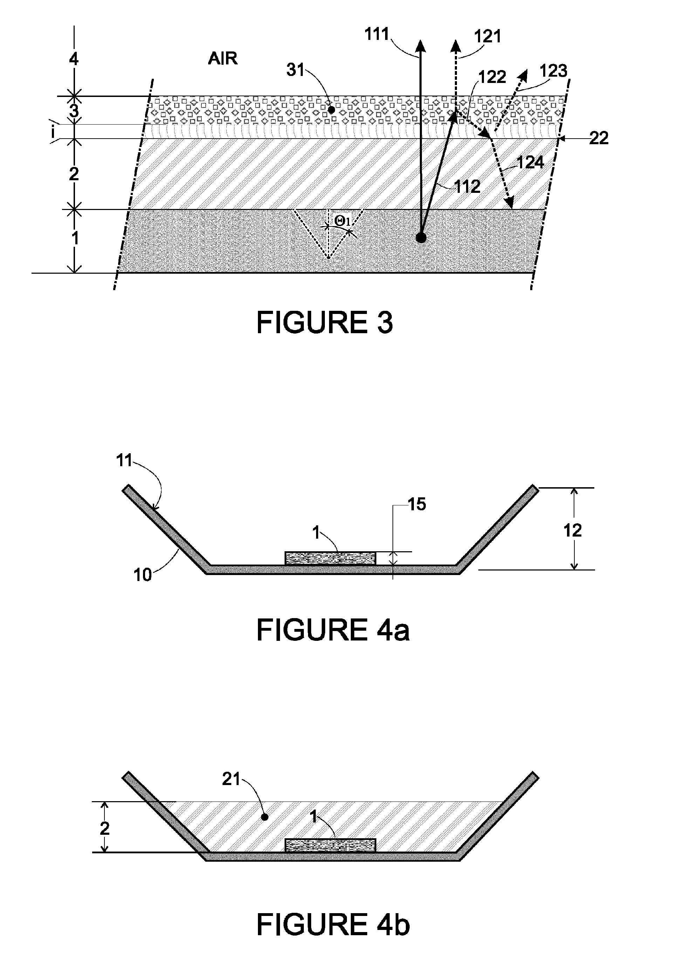

La **figure 3** illustre le principe de fonctionnement d'un exemple de composant LED selon l'invention à l'aide d'une vue en coupe montrant les différentes couches d'une structure permettant d'améliorer l'efficacité d'extraction de la lumière produite.

Par comparaison avec la figure 2, l'invention introduit une couche de réflexion située entre la puce 1 et la couche de conversion 3 comprenant des luminophores. Cette couche est notée (i) ci-après. Elle a pour but, sinon d'annuler, de tout au moins fortement limiter le retour et la réabsorption par la puce 1 de la partie du rayonnement secondaire qui est réémis dans cette direction par les luminophores 31 de cette couche. La couche de réflexion (i) est donc placée entre la couche 2 d'encapsulation de la puce 1 et la couche de conversion 3 formant la source secondaire. Le rôle essentiel de la couche de réflexion est, comme on va le voir, de favoriser la réflexion totale vers l'extérieur du dispositif, du rayonnement secondaire à l'interface 22 entre la couche (i) et la couche 2. Elle est également conformée pour laisser passer le rayonnement primaire 111, 112. On rappelle qu'en optique géométrique, on qualifie usuellement de réflexion totale le phénomène qui survient lorsqu'un rayon lumineux arrive à une interface formée par deux milieux d'indices optiques n1 et n2 différents avec un angle d'incidence supérieur à l'angle limite Arcsin(n2/n1), l'angle d'incidence étant formé par la direction du rayon et la normale au plan défini par l'interface. Au-delà ce cet angle limite, les rayons incidents ne sont plus transmis et sont tous réfléchis.

La source primaire de lumière est la puce LED 1. Il s'agit, par exemple, d'une puce LED dont le semi-conducteur est typiquement du nitrure de gallium (GaN) dont l'indice de réfraction est 2,4. Comme on l'a vu précédemment, ce type de puce LED émet une lumière bleue dans une gamme de longueur d'ondes typiquement centrée sur 450 nm. Une partie du rayonnement incident 111 est transmise et extraite directement du dispositif. L'autre partie 112 va interagir avec les luminophores 31 de la couche de conversion 3.

Avant d'atteindre la couche de conversion 3, le rayonnement primaire traverse d'abord la couche 2 d'encapsulation de la puce 1. Cette couche est donc constituée d'un matériau transparent à ce rayonnement et a un faible indice de réfraction pour pouvoir constituer, avec la couche de réflexion (i) dont l'indice de réfraction est plus élevé, une interface réfléchissante 22 pour le rayonnement 122 qui est réémis par la couche de conversion 3 vers l'intérieur du dispositif. Le matériau de la couche 2 est par exemple un polymère de silicone dont l'indice de réfraction vaut 1,4. Le rayonnement primaire 111, 112 traverse aussi la couche de réflexion (i) qui doit donc être également transparente au rayonnement primaire et dont les autres caractéristiques sont discutées ci-après.

La couche de matériau luminescent, qui constitue la source secondaire de lumière, absorbe donc la partie 112 du rayonnement incident qui n'est pas transmise directement vers l'extérieur et réémet un rayonnement de longueur d'onde différente, typiquement supérieure, de la longueur d'onde du rayonnement primaire. Comme on l'a vu en figure 1, avec une source primaire bleue, la source secondaire est choisie pour réémettre dans la couleur complémentaire : le jaune. Le rayonnement converti est réémis pour moitié 121 vers l'extérieur et participe directement au rayonnement lumineux généré par le dispositif. L'autre moitié 122 est réémise vers l'intérieur du dispositif. C'est cette moitié du rayonnement converti qui va être, pour l'essentiel, réfléchie à l'interface 22 entre la couche (i) et la couche 2. Seule une faible fraction résiduelle 124 du rayonnement converti réémis vers l'intérieur du dispositif parviendra jusqu'à la puce LED 1 pour contribuer marginalement à son échauffement.

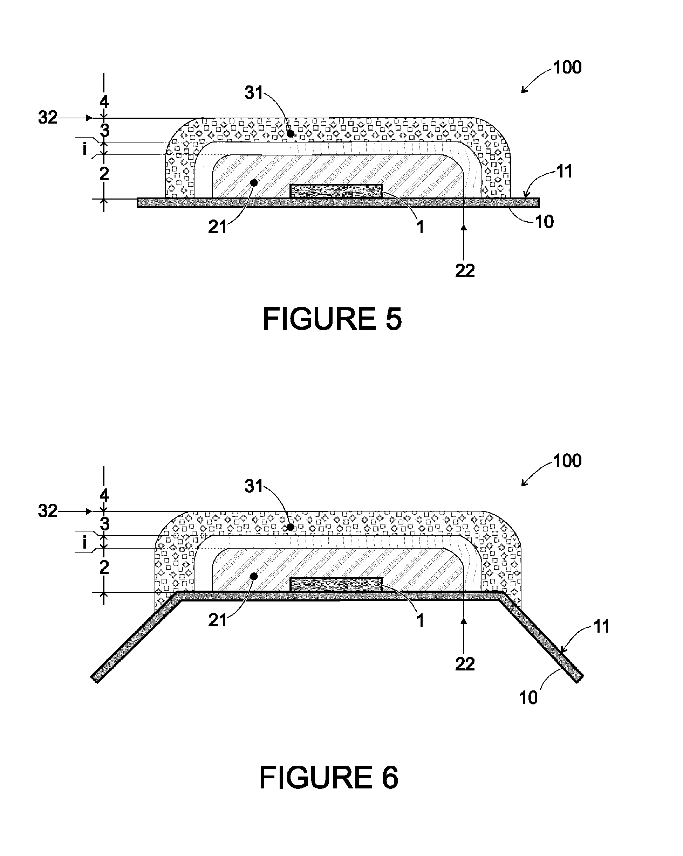

Le procédé de l'invention, qui va être décrit dans les figures 5a à 5g ci-après, permet en effet de créer une interface 22 entre la couche de réflexion (i) et la couche d'encapsulation 2, qui a un caractère spéculaire, ou quasi spéculaire, pour la partie du rayonnement converti 122 réémis vers l'intérieur du dispositif. Cette interface 22 maximise la réflexion 123 de ce rayonnement vers l'extérieur, contribuant ainsi à l'efficacité lumineuse du dispositif. L'interface 22 est d'autant plus efficace que la fraction résiduelle 124 du rayonnement sera faible maximisant ainsi l'extraction de lumière du dispositif et minimisant l'échauffement de la puce 1.

L'ajout d'une couche de réflexion (i) permet d'obtenir ces résultats en ayant les caractéristiques suivantes :
- la couche (i) est transparente au rayonnement primaire et aussi au rayonnement secondaire afin que la réflexion spéculaire se fasse au niveau de l'interface 22 avec la couche d'encapsulation 2.
- La couche (i) est optiquement homogène. Elle est de préférence monolithique, c'est-à-dire qu'elle est formée par un unique matériau et préférablement formée d'une seule couche de cet unique matériau. Selon un autre mode de réalisation, elle est formée d'un empilement de matériaux dont les indices optiques sont égaux, conservant ainsi l'homogénéité optique de la couche de réflexion. La couche (i) a un indice de réfraction tel que l'indice nᵢ de la couche (i) est supérieur à l'indice de réfraction n₂ de la couche 2. Cette condition est nécessaire pour qu'il puisse y avoir effectivement réflexion totale d'une partie du rayonnement 122, réémis depuis la couche de conversion 3 vers l'intérieur du dispositif, à l'interface 22 entre ces deux couches.
- Le comportement de réflexion spéculaire de l'interface 22 est obtenu en ayant une bonne planéité de la surface caractérisée par une rugosité moyenne dont l'amplitude est très petite devant la longueur d'onde (λ) de la lumière à réfléchir, c'est-à-dire le rayonnement secondaire jaune dans ce cas, divisé par l'indice de réfraction de la couche d'encapsulation (n₂). La rugosité moyenne de l'interface 22 est de préférence inférieure à 10 nm. Le procédé de l'invention, décrit dans les figures 4a à 4f ci-après, permet d'atteindre cet objectif qui confère à l'interface 22 un comportement de réflexion spéculaire.

Dans la présente invention, on considère que le contact entre la couche d'encapsulation 2 et la couche de réflexion (i) est suffisamment intime pour que les faces de ces deux couches 2 (i), qui sont en regard, présentent sensiblement la même rugosité. Cette rugosité commune définit la rugosité de l'interface 22.

On notera également que l'efficacité de réflexion, liée à la réflexion totale à l'interface entre la couche de réflexion et la couche d'encapsulation est d'autant plus grande que le ratio nᵢ/n₂ est grand et que n₃ est proche de nᵢ. Dans le cas optimum ou n₃=nᵢ, la fraction de lumière subissant une réflexion totale à l'interface 2/i est égale à cos(arcsin(n₂/nᵢ)). Par exemple, pour nᵢ = n₃ = 2,1 et n₂ = 1,4, tous les photons arrivant à l'interface entre la couche d'encapsulation 2 et la couche de réflexion (i) avec une incidence supérieure à θ = Arcsin(1,4/2,1) = 42°, sont réfléchis à cette interface 2/(i). En considérant une émission secondaire isotrope, cela correspond à environ 75% du rayonnement secondaire réémis vers la puce 1 qui sera réfléchi par l'interface 22. Ainsi, la réflexion est totale pour l'ensemble des rayons parvenant à l'interface 2/(i) avec un angle d'incidence supérieure à un angle donné. Elle n'est que partielle si l'on considère l'ensemble de tous les rayons, quel que soit leur angle d'incidence.
- La couche de matériau luminescent, si elle est optiquement homogène, doit avoir un indice de réfraction (n₃) tel que n₃ est supérieur ou égal à n₂. Si, comme c'est le plus souvent le cas, la couche de conversion 3 est composite et faite de luminophores enrobés par exemple, comme déjà mentionné précédemment, dans une matrice organique polymère, c'est l'indice nₘ de cette matrice qui doit alors être supérieur à n₂, l'indice de la couche d'encapsulation.
- L'efficacité du dispositif décroît si le rapport n₃/ni est inférieur à 1. Dans ce cas, la réfraction à l'interface (i)-3 resserre la distribution angulaire de l'émission secondaire près de la normale, et une fraction plus faible de l'émission arrive à l'interface (i)-2 avec des incidences au delà de l'angle de réflexion totale. Cette fraction vaut cos(arcsin(n₂/n₃)). Par exemple, si n₃ = 1,8 et n2=1.5 seulement 50 % du flux secondaire sera totalement réfléchit à l'interface 2-(i). Dans ce cas, avantageusement l'interface (3)/(i) est réalisée de façon à avoir un comportement diffus, c'est à dire ayant une rugosité Ra supérieure à 50 nm, de manière à redistribuer une plus grande fraction de la lumière secondaire sur des angles d'incidence supérieurs à l'angle de réflexion total donné par arcsin(n2/ni).
- Enfin, chaque couche est déposée avec une épaisseur supérieure à la longueur d'onde des rayonnements considérés, divisée par l'indice de réflexion de la couche pour éviter les phénomènes d'interférences qui pourraient se produire dans des couches minces. Typiquement, les couches déposées sont supérieures à 500 nm, c'est-à-dire 700/1,4.

On notera ici que contrairement à l'art antérieur cité dans le chapitre sur l'état de la technique, où un filtre optique, basé sur des phénomènes d'interférences dans un empilement de couches d'épaisseurs soigneusement contrôlées, est utilisé pour réfléchir le rayonnement secondaire vers l'extérieur, l'invention ne demande pas de pouvoir contrôler l'épaisseur des couches déposées autrement qu'en spécifiant une valeur minimale. Ce qui est très facilement obtenu avec n'importe lequel des procédés de dépôt couramment utilisés par l'industrie de la microélectronique.

On remarquera également que l'introduction de la couche de réflexion (i) permet de s'affranchir de la qualité réfléchissante de l'interface avec la couche de conversion 3 formant la source secondaire. La couche de conversion 3 contient typiquement des luminophores de relativement grosses tailles, il est alors impossible d'avoir une qualité optique suffisante, c'est-à-dire une faible rugosité, qui permettrait d'obtenir une réflexion spéculaire à cette interface. Dans l'art antérieur mentionné, US 2009/0272996, l'introduction d'une couche d'espacement entre la couche de conversion 3 et la puce 1, qui n'est pas différente dans son principe de la couche 2, si elle participe en effet à l'amélioration de l'efficacité d'extraction, ne peut cependant faire que la rugosité de l'interface soit améliorée. Au contraire, l'invention s'affranchit de cette limitation en introduisant une couche supplémentaire de réflexion optique (i) qui permet de ne pas avoir à imposer de critère particulier quant au caractère spéculaire ou diffusant de l'interface entre la couche de conversion 3 et la couche de réflexion (i).

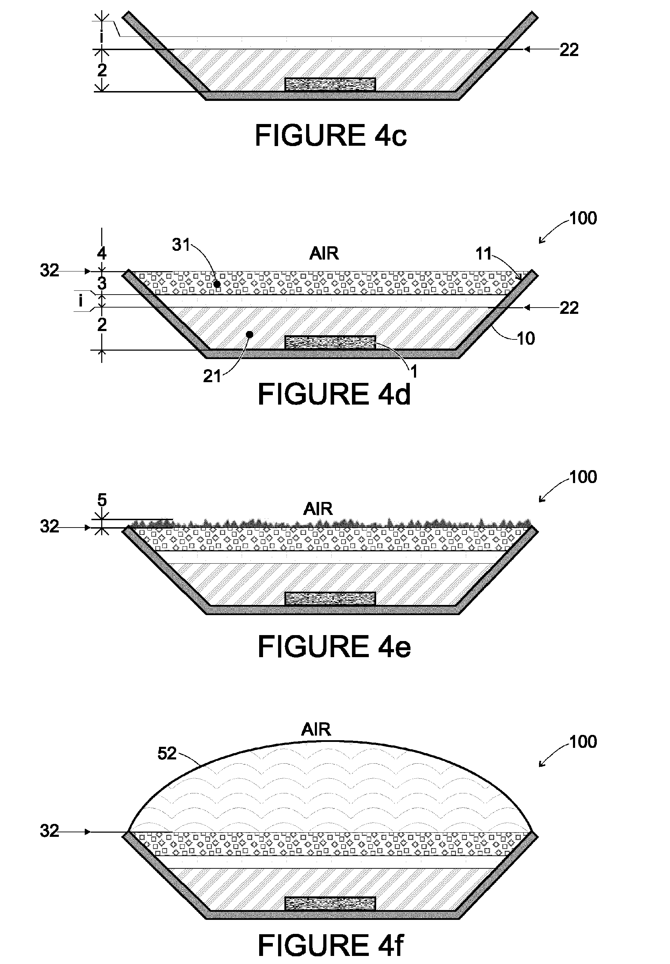

Enfin, comme on va le voir ci-après dans les figures 4e et 4f, l'extraction de la lumière produite par les sources primaire et secondaire peut aussi être maximisée à l'interface entre la couche de conversion 3 et l'environnement, c'est-à-dire l'air 4. Plusieurs options de réalisation sont décrites dans ces figures.

Les **figures 4a à 4f** illustrent le procédé qui permet la réalisation de composants LED 100, par exemple émettant une lumière blanche et dont la structure est conforme aux principes de fonctionnement de l'invention exposés dans la figure précédente.

La **figure 4a** illustre la première étape où une puce 1 est placée dans un support 10. Typiquement, le support 10 forme un boîtier. Il est par exemple en céramique et présente une cavité métallisée réfléchissante 11. La puce 1 et le support peuvent être des composants spécialisés qui ont été développés par un fabricant pour une application particulière. Ce type de composants est aussi disponible commercialement auprès de fabricants spécialisés. En ce qui concerne la puce LED 1, comme déjà mentionné, il s'agira par exemple de diodes à base de nitrure de gallium (GaN) ou encore de nitrure de gallium et d'indium (InGaN) qui émettent typiquement dans une gamme de longueur d'ondes centrée sur 450 nm. La société « Cree », dont le siège social est aux États-Unis, 4600 Silicon Drive, Durham, NC 27703, fournit ce genre de dispositifs, dans une gamme de produits dite « EZBright », fabriqués à partir de nitrure de gallium et d'indium. Le support peut, par exemple, provenir de la société japonaise « KYOCERA Corporation » dont le siège social est 6 Takeda Tobadono-cho, Fushimi-ku, Kyoto, Japon. En utilisant des procédés classiques de l'industrie de la microélectronique, la puce 1 est fixée dans le support 10 et interconnectée électriquement à celui-ci (les interconnexions ne sont pas représentées sur la figure 4a). A titre indicatif, l'épaisseur 15 typique de la puce 1 est de l'ordre d'une centaine de micromètres (micromètre ou µm = 10⁻⁶ mètre) et la hauteur 12 du support est d'environ 500 µm. Ces dimensions ne sont pas limitatives de l'invention et peuvent varier dans une large plage de valeurs en fonction des applications. Typiquement, la hauteur du support, pour des applications impliquant de fortes puissances, peut atteindre jusqu'à 20 millimètres.

La **figure 4b** illustre le résultat de la seconde étape après que la couche d'encapsulation 2 de la puce 1 a été formée. Le matériau encapsulant 21 utilisé est, par exemple, un polymère transparent de type silicone disponible sous forme liquide. Ce type de matériau est disponible commercialement par exemple auprès de la société « NuSil Silicone Technology » dont le siège social est aux États-Unis, 1050 Cindy Lane, Carpinteria, CA 93013, sous la référence LS 3441. L'indice de réfraction de ce matériau est de 1,4 qui correspond bien à l'objectif fixé pour cette couche, comme discuté dans la description de la figure 3. La cavité du support est remplie typiquement aux trois-quarts de sa hauteur, soit environ sur 375 µm, puis le polymère est réticulé. Par capillarité, la réticulation permet d'obtenir une surface parfaitement plane d'une rugosité Ra inférieure ou égale à 40nm et de préférence inférieure ou égale à 10 nm. La réticulation du polymère et sa solidification sont obtenues par exemple thermiquement en chauffant le dispositif.

La **figure 4c** illustre l'étape suivante durant laquelle la couche de réflexion (i) est formée. Comme on l'a vu précédemment, cette couche doit avoir de préférence un fort indice de réfraction (nᵢ) et, en tout état de cause, un indice supérieur à celui (n₂) de la couche d'encapsulation 2 pour que la réflexion spéculaire à l'interface 22 entre ces deux couches puisse se faire. La réflexion sera d'autant plus grande que l'indice de la couche de réflexion est élevé. Pour déposer la couche de réflexion (i), on a recours de préférence à une « déposition physique en phase vapeur » qui regroupe un ensemble de méthodes connues sous l'acronyme général de PVD, de l'anglais « physical vapor deposition ». On dépose par PVD, sous vide, une couche mince de l'ordre de 500 nm d'un matériau comme par exemple le TiO₂. Le dépôt de la couche (i) pourra aussi se faire sans inconvénient sur les parois intérieures du support formant le boîtier (non représenté). Ce matériau présente bien, comme souhaité, un indice élevé de réfraction de 2,4.

La **figure 4d** montre le résultat de l'étape suivante où l'on procède au dépôt de la couche de conversion 3. Il s'agit de déposer un matériau luminescent 31 comme par exemple le YAG décrit précédemment. A l'issue de ce dépôt on obtient alors le composant LED 100.

La couche de conversion 3 est constituée de préférence de luminophores dont la taille caractéristique est micronique, avantageusement dans une large gamme allant de 0,05 à 50 µm et de préférence dans une gamme de 1 à 10 µm. De manière particulièrement avantageuse, les luminophores peuvent également être des nanophosphores dont la taille est inférieure à 500 nanomètres et encore plus avantageusement inférieure à 100 nanomètres. Les luminophores sont mélangés à un silicone, par exemple du type de ceux fournis par la société « NuSil Silicone Technology » déjà mentionnée ci-dessus, et en particulier un silicone dont la référence est LS 3357 et dont l'indice de réfraction vaut 1,6. La proportion massique de matériau luminescent dans le mélange est de préférence, en poids, de l'ordre de 15%. Tous les constituants de cette couche ont un indice de réfraction supérieur à celui de la couche d'encapsulation 2. Généralement disponible sous forme liquide, le matériau de la couche de conversion 3 est par exemple dispensé dans les supports formant les dispositifs. La dispense peut par exemple être effectuée à la seringue. La réticulation et la solidification du matériau de la couche de conversion 3 sont obtenues thermiquement comme pour la couche d'encapsulation 2.

A ce stade de la description du procédé il convient de remarquer que l'extraction des rayonnements primaire et secondaire du composant LED 100 vers le milieu extérieur, l'air 4, peut être encore optimisée si l'interface 32 de la couche de conversion 3 avec l'air 4 du milieu extérieur est diffusante. Pour obtenir que cette interface s'éloigne le plus possible d'un comportement spéculaire et soit effectivement diffusante, en élargissant l'angle de diffusion de la lumière et en rendant cette diffusion la plus homogène possible, l'invention considère la mise en oeuvre des deux options suivantes illustrées par les figures 4^{e} et 4f.

Comme montré dans la **figure 4e** une première option consiste à créer une forte structuration 5 de l'interface 32 du composant LED 100 pour avoir une rugosité dont l'amplitude est typiquement supérieure à 50 nm. Cette structuration est par exemple obtenue à l'aide de l'une ou l'autre des méthodes suivantes :
- Si la taille des luminophores est largement supérieure à 10 nm, par exemple supérieure à 50 nm alors l'interface est auto diffusante, et il n'est pas nécessaire de créer une structuration supplémentaire.
- par application d'un moule rugueux à la surface pendant l'étape de réticulation de la couche de conversion 3.
- ou alors par un procédé de gravure chimique ou plasma.

La **figure 4f** décrit une seconde option où l'on applique sur le composant LED 100 une lentille hémisphérique transparente 52 en verre ou en matériau polymère inorganique par collage au moyen d'un matériau de type silicone comme par exemple celui portant la référence LS 6257 de la société « NuSil Silicone Technology » déjà mentionnée.

En plus des exemples précis qui viennent d'être décrits, l'invention couvre également de nombreuses variantes dont une liste non limitative est indiquée ci-après :
- une étape où la structuration de l'interface (i)/(3) est obtenue par un procédé de gravure plasma ou de gravure chimique adapté au matériau constitutif de la couche (i) ou encore un procédé de polissage de façon à obtenir une rugosité Ra supérieure à 50 nm afin de conférer à l'interface (i)/(3) un caractère diffusant.
- selon les caractéristiques désirées de la source de lumière, la puce 1 constituant la source primaire peut émettre dans une gamme de longueurs d'ondes autre que celle qui a servi à illustrer l'invention (dans le bleu, autour de 450 nm). En particulier, la source primaire 1 peut s'étendre de l'ultraviolet au domaine visible par exemple dans une gamme de longueurs d'ondes allant de 200 à 800 nm. Le matériau semi-conducteur constitutif de la puce LED peut être à base d'autres matériaux semi-conducteurs que ceux cités, c'est-à-dire le nitrure de gallium (GaN) et le nitrure d'indium et de gallium (InGaN) Le nitrure d'aluminium (AlN), le nitrure d'aluminium et de Gallium (AlGaN) ainsi que les matériaux suivants : InAlGaN, GaP, GaAsP, InGaAlP, conviennent.
- En particulier l'oxyde de zinc (ZnO) est un matériau qui convient.
- On notera que la zone active de la puce LED peut se présenter classiquement sous la forme de couches mais également sous la forme de nanofils.
- Le support 10 aura de préférence une cavité avec des parois réfléchissantes métalliques ou faites d'un polymère réflecteur. Le support 10 peut également être sans cavité comme dans les exemples des figures 5 et 6 qui montrent des supports 10 formant respectivement un boîtier plan et un boîtier convexe. Dans ces deux derniers modes de réalisation, les différentes couches sont de préférence moulées dans un moule rapporté sur le support 10. L'ensemble des caractéristiques de dispositif et étapes de procédé décrites pour le mode de réalisation avec support concave sont applicables à et peuvent être combinées avec ces deux modes de réalisation.

Le mode de réalisation illustré en figure 5, dans lequel le support 10 recevant la puce LED 1 est plan, présente pour avantage d'être particulièrement simple à réaliser et d'induire un coût d'obtention réduit.

Le mode de réalisation illustré en figure 6, dans lequel le support 10 recevant la puce LED 1 est convexe, permet avantageusement d'émettre de la lumière dans un intervalle élargi d'angle d'émission. Cet intervalle est en effet supérieur à 180 degrés puisque de part et d'autre de la puce LED 1 on peut émettre au-delà du plan sur lequel repose la puce LED 1. De préférence, la couche de conversion 3 repose au moins en partie sur des portions convexes du support 10. On obtient alors une source de lumière dont l'indicatrice d'émission est supérieure à 180°.

La puce 1 est alors fixée de préférence sur une embase plane céramique ou métallique comprenant les couches d'interconnexion électrique nécessaires. La couche de conversion 3 en matériau luminescent forme dans ce cas un dôme au dessus de la puce LED 1. Ce dôme peut être de forme rectangulaire, hémisphérique ou autre.
- Dans ce cas, un exemple de réalisation est décrit ci-après. On effectue une étape de dépôt de la couche de conversion dans un moule dont la forme intérieure correspond à la forme que l'on veut donner à la couche de conversion 3. Sur l'exemple illustré, le moule présente donc une forme intérieure en dôme. Vu du dessus, le dôme peut présenter une forme circulaire, rectangulaire, carrée, triangulaire, polygonale etc. On dépose ensuite la couche de réflexion i sur la couche de conversion 3. On dépose ensuite la couche de matériau encapsulant sur la couche de réflexion i. De préférence, les matériaux formant les couches de conversion, de réflexion et d'encapsulation sont liquides et sont coulés pour former les couches 3, i et 2. On forme par ailleurs un ensemble comprenant la puce LED 1 positionnée sur le support 10. On reporte ensuite cet ensemble dans l'empilement de sorte à plonger la puce LED dans la couche d'encapsulation 3.

Enfin, on effectue une étape pour figer, par exemple par réticulation, la structure ainsi obtenue,

Typiquement, lors de la formation de l'empilement de couches, les différentes couches sont déposées par gravité dans le moule en commençant par la couche de conversion 3 qui est donc la couche inférieure. Après l'étape de report de la puce LED 1 dans l'empilement de couches et de préférence après l'étape de réticulation, on fait pivoter la structure de 180° pour obtenir la structure illustrée en figure 5 ou 6.

Il convient de s'assurer que l'interface (i)/2 formée par la couche de réflexion i et la couche d'encapsulation 2, présente une faible rugosité comme explicité précédemment. A cet effet, une attention particulière sera apportée à la taille des particules de la couche de conversion 3 afin que la couche de réflexion (i) présente une rugosité Ra inférieure à 50 nm. Si les particules 31 de la couche de conversion 3 ont une granulométrie trop importante et que la couche de conversion 3 est déposée en premier, alors la couche suivante, c'est-à-dire la couche de réflexion i va épouser les reliefs de la surface de la couche de conversion 3. La couche de réflexion i risque alors de présenter une rugosité supérieure à 50 nm si la granulométrie des particules de la couche 31 est trop importante. On privilégiera alors des particules luminescentes dont la taille est inférieure à 10 micromètres, voire inférieure à 1 micromètre, voire inférieure à 100 nanomètres.
- le matériau encapsulant 21 peut être, par exemple, un polymère organique de type silicone, époxy ou acrylique mais également un matériau inorganique comme un verre. L'indice de réfraction sera typiquement compris dans une gamme allant de 1,4 à 1,8.
- Le matériau formant la couche de réflexion (i) transparente doit avoir un indice de réfraction le plus élevé possible. Il est de préférence nettement plus élevé que celui du matériau 21 de la couche d'encapsulation 2 de manière à avoir la plus large fraction du rayonnement secondaire réfléchie à l'interface 22 par réflexion totale. La couche de réflexion (i) peut avantageusement utiliser des matériaux inorganiques obtenus par des dépôts en couches minces à l'aide d'une technique dite PVD, déjà mentionnée, et aussi par CVD, acronyme de l'anglais « chemical vapor deposition », c'est-à-dire « dépôt chimique en phase vapeur ». Les matériaux suivants conviennent : le sulfure de zinc (ZnS), l'oxyde de zinc (ZnO) ou l'oxyde de titane (TiO₂) qui ont un indice de réfraction d'environ 2,4. L'oxyde d'étain et d'indium (ITO), l'oxyde d'indium (In₂0₃), l'oxyde de zirconium (ZrO₂), l'oxyde de hafnium (HfO₂), le nitrure de silicium (Si₃N₄) et l'oxyde de tantale (Ta₂O₅) dont les indices de réfraction sont compris entre 2 et 2,2 environ peuvent aussi convenir, seuls ou sous forme d'un co-dépôt de plusieurs de ces matériaux. Comme on l'a vu, l'épaisseur de la couche de réflexion doit être de préférence supérieure à 400 nm. Elle reste avantageusement inférieure à 1 µm notamment pour les matériaux semi-conducteurs comme le ZnS, ITO, ZrO₂ ou In₂O₃, qui sont partiellement absorbant pour les longueurs d'ondes considérées. D'autres méthodes comme l'électrolyse peuvent éventuellement être employées pour déposer des matériaux comme l'oxyde de zinc (ZnO). Enfin, même si c'est plus complexe technologiquement, il est possible de réaliser cette couche intermédiaire par un composite comprenant une matrice organique de silicone par exemple et l'ajout de nano particules, de dimensions inférieures à 50 nm, dans les mêmes matériaux mentionnés ci-dessus, conférant à cette couche un caractère optiquement homogène.
- La couche 3 formant la source secondaire contient un matériau luminescent de conversion de la longueur d'onde primaire sous forme de luminophores. Comme mentionné précédemment, le plus courant est le grenat d'yttrium et d'aluminium dopé au cérium (YAG :Ce). Il existe cependant une grande variété de luminophores jaunes, verts ou encore rouges qui peuvent être aussi utilisés en fonction des applications de l'invention de façon à obtenir les propriétés colorimétriques désirées. Avantageusement, l'indice de cette couche sera le plus élevé possible et en tout cas supérieur à celui de la couche d'encapsulation 2. Idéalement il sera égal ou supérieur à l'indice de la couche de réflexion. Le YAG:Ce a un indice de 1,8 et la majorité des matériaux luminescents ont un indice de réfraction supérieur à cette valeur. Il est possible d'augmenter l'indice effectif de la matrice de la couche de conversion 3 en ajoutant des nano particules d'un matériau d'indice élevé comme mentionné ci-dessus. Par exemple, il est possible d'utiliser un polymère silicone chargé en particules de TiO2, ZrO_{2,} ZnO et ZnS.

Ainsi, les objectifs de l'invention sont atteints avec un procédé simple et peu coûteux de réalisation d'un composant LED, par exemple blanche, qui permet cependant d'optimiser l'extraction du rayonnement primaire provenant de la puce LED et du rayonnement converti par la couche de matériau luminescent. L'invention permet d'obtenir un composant ayant un faible facteur de forme dont la taille n'excède pas, par un facteur de plus de deux à trois, la taille de la puce 1 nécessaire à la génération du rayonnement primaire.

En outre, l'invention permet de dissocier la fonction spéculaire de l'interface où la réflexion totale du rayonnement réémis par la couche de conversion vers la puce est recherchée, et la fonction conversion/diffusion de la couche de matériau luminescent. Ainsi, les critères spécifiques à la couche de conversion ne sont pas déterminés par cette contrainte. Il donc n'est pas nécessaire d'employer des nano particules pour cette couche comme c'est le cas dans l'art antérieur cité dans le chapitre sur l'état de la technique, répondant ainsi à un objectif de l'invention d'avoir un procédé de fabrication simple et peu coûteux.

Avantageusement, il n'est pas nécessaire non plus de contrôler finement l'épaisseur des couches de matériaux constituant le composant LED à la différence de solutions de l'art antérieur reposant sur une réflexion par effet d'interférences où il faut au contraire pouvoir contrôler précisément les épaisseurs.

L'invention n'est pas limitée aux modes de réalisation précédemment décrits et s'étend à tout mode de réalisations conforme à son esprit.

## Revendications

1. Composant diode électroluminescente (100) comportant :
• au moins une source primaire (1) configurée pour émettre un rayonnement primaire (111, 112) lorsqu'elle est activée électriquement,
• au moins une couche de conversion (3) formant une source secondaire configurée pour absorber au moins en partie le rayonnement primaire (112) et émettre un rayonnement secondaire (121, 122),
• au moins une couche d'encapsulation (2) disposée au contact de la source primaire (1) et configurée pour laisser passer le rayonnement primaire (111, 112) émis par la source primaire (1) en direction de la source secondaire,
**caractérisé en ce qu'il** comprend :
une couche de réflexion (i) optiquement homogène, située entre la couche d'encapsulation (2) et la couche de conversion (3) et présentant une face au contact de la couche de conversion (3) et une face au contact de la couche d'encapsulation (2) de manière à former une interface (22) avec la couche d'encapsulation (2), la couche de réflexion (i) et la couche d'encapsulation (2) étant configurées de manière à ce que ladite interface (22) laisse passer le rayonnement primaire (111, 112) issu de la source primaire (1) et de manière à ce que les rayons du rayonnement secondaire (122) émis en direction de ladite interface (22) et arrivant sur ladite interface (22) avec un angle supérieur à Arcsin(n₂/nᵢ) par rapport à une perpendiculaire à ladite interface (22) soient réfléchis par réflexion totale, n₂ et nᵢ étant les indices de réfraction respectifs de la couche d'encapsulation (2) et de la couche de réflexion (i).

2. Composant diode électroluminescente (100) selon la revendication précédente, dans lequel la couche de réflexion (i) et la couche d'encapsulation (2) sont configurées pour que l'indice de réfraction nᵢ de la couche de réflexion (i) soit supérieur à l'indice de réfraction n₂ de la couche d'encapsulation (2) et pour que la face de la couche de réflexion (i) au contact de la couche d'encapsulation (2) présente une rugosité Ra inférieure à 50 nm.

3. Composant diode électroluminescente (100) selon la revendication précédente, dans lequel la face de la couche de réflexion (i) au contact de la couche d'encapsulation (2) présente une rugosité Ra inférieure à 5 nm.

4. Composant diode électroluminescente (100) selon l'une quelconque des deux revendications précédentes, dans lequel la couche de réflexion (i) et la couche d'encapsulation (2) sont configurées de sorte que nᵢ/n₂ > 1,2 et de préférence de sorte que nᵢ/n₂ > 1,4.

5. Composant diode électroluminescente (100) selon l'une quelconque des revendications précédentes, dans lequel la couche de conversion (3) formant une source secondaire et la couche de réflexion (i) sont configurées de sorte que l'indice de réfraction n₃ de la couche de conversion (3) est supérieur à l'indice de réfraction nᵢ de la couche de réflexion (i).

6. Composant diode électroluminescente (100) selon l'une quelconque des revendications précédentes, dans lequel la couche d'encapsulation (2) est disposée au contact de la source primaire (1).

7. Composant diode électroluminescente (100) selon l'une quelconque des revendications précédentes, dans lequel la couche de réflexion (i) est en un matériau (31) pris parmi : le sulfure de zinc (ZnS), l'oxyde de zinc (ZnO), l'oxyde de titane (TiO₂), l'oxyde d'étain et d'indium (ITO), l'oxyde d'indium (In₂0₃), l'oxyde de zirconium (ZrO₂), l'oxyde de hafnium (HfO₂), le nitrure de silicium (Si₃N₄) et l'oxyde de tantale (Ta₂O₅).

8. Composant diode électroluminescente (100) selon l'une quelconque des revendications précédentes, dans lequel l'épaisseur e₂ de la couche d'encapsulation, l'épaisseur eᵢ de la couche de réflexion (i) et l'épaisseur e₃ de la couche de conversion (3) sont telles que e₂>λ/n₂, eᵢ>λ/nᵢ, e₃>λ/n₃, n₂, nᵢ et n₃ étant respectivement les indices de réfraction de la couche d'encapsulation (2), de la couche de réflexion (i) et de la couche de conversion (3) et λ étant la longueur d'onde la plus élevée de la gamme d'ondes du rayonnement primaire.

9. Composant diode électroluminescente (100) selon l'une quelconque des revendications précédentes, dans lequel l'épaisseur de la couche d'encapsulation (2) est comprise entre 0,5 µm et 5 mm et dans lequel l'épaisseur de la couche de réflexion (i) est comprise entre 0, 4 µm et 5 µm.

10. Composant diode électroluminescente (100) selon l'une quelconque des revendications précédentes, dans lequel la couche de conversion (3) comprend une face externe tournée vers l'extérieur du composant diode électroluminescente (100), cette face externe présentant une rugosité (5) supérieure à 50nm.

11. Composant diode électroluminescente (100) selon l'une quelconque des revendications 1 à 9, dans lequel la couche de conversion (3) comprend une face externe tournée vers l'extérieure du composant diode électroluminescente (100) et le composant diode électroluminescente (100) comprend une lentille hémisphérique (52) disposée entre ladite face externe et l'extérieur.

12. Composant diode électroluminescente (100) selon l'une quelconque des revendications précédentes, dans lequel la source primaire (1), la couche d'encapsulation (2) et la couche de réflexion (i) au moins sont logées dans une cavité.

13. Composant diode électroluminescente (100) selon la revendication précédente, dans lequel la cavité est formée par un support (10) présentant des parois intérieures (11) réfléchissantes.

14. Composant diode électroluminescente (100) selon la revendication 12, dans lequel la cavité est formée par la source secondaire.

15. Composant diode électroluminescente (100) selon l'une quelconque des revendications 1 à 11, dans lequel la source primaire (1) repose sur un support (10) présentant une forme convexe ou une forme plane.

16. Système d'éclairage, d'affichage ou de signalisation comportant au moins un composant diode électroluminescente (100) selon l'une quelconque des revendications précédentes.

17. Procédé de fabrication d'un composant diode électroluminescente (100) comprenant les étapes suivantes :
• disposer au moins une source primaire (1) configurée pour émettre un rayonnement primaire (111, 112) lorsqu'elle est activée électriquement,
• disposer au moins une couche de conversion (3) formant une source secondaire configurée pour absorber au moins en partie (112) le rayonnement primaire (111, 112) et émettre un rayonnement secondaire (121, 122),
• disposer au moins une couche d'encapsulation (2) au contact de la source primaire (1) et entre les sources primaire (1) et secondaire, la couche d'encapsulation (2) étant configurée pour laisser passer le rayonnement (111, 112) émis par la source primaire en direction de la source secondaire, **caractérisé en ce qu'il** comprend l'étape suivante: disposer une couche de réflexion (i) optiquement homogène entre la couche d'encapsulation (2) et la couche de conversion (3) de sorte qu'une face de la couche de réflexion (i) soit au contact de la couche de conversion (3) et qu'une autre face de la couche de réflexion (i) soit au contact de la couche d'encapsulation (2) pour former une interface (22) avec la couche d'encapsulation (2), la couche de réflexion (i) et la couche d'encapsulation (2) étant choisies pour que ladite interface (22) laisse passer le rayonnement primaire (111, 112) issu de la source primaire (1) et de manière à ce que les rayons du rayonnement secondaire (122) émis en direction de l'interface (22) et arrivant sur ladite interface (22) avec un angle supérieur à Arcsin(n₂/nᵢ) par rapport à une perpendiculaire à ladite interface (22) soient réfléchis par réflexion totale, n₂ et nᵢ étant les indices de réfraction respectifs de la couche d'encapsulation (2) et de la couche de réflexion (i) et nᵢ étant supérieur à n₂.

18. Procédé selon la revendication précédente comprenant une étape de fixation de la source primaire (1) sur un support (10), une étape de dispense sous forme liquide et de réticulation de la couche d'encapsulation (2), une étape de formation de la couche de réflexion (i) et une étape de dispense sous forme liquide et de réticulation de la couche de conversion (3).

19. Procédé selon la revendication précédente dans lequel l'étape de formation de la couche de réflexion (i) comprend un dépôt d'un matériau formant la couche de réflexion (i) par voie chimique ou physique en phase vapeur (PVD ou CVD) sur la couche d'encapsulation (2).

20. Procédé selon la revendication 17 dans lequel les étapes de disposition de la couche de conversion (3), de la couche de réflexion (i) et de la couche d'encapsulation (2) comprennent respectivement une étape de dépôt de la couche de conversion (3) dans un moule, une étape de dépôt de la couche de réflexion (i) sur la couche de conversion (3), une étape de dépôt de la couche d'encapsulation (2) sur la couche de réflexion (i), le procédé comprenant en outre une étape de report de la puce LED (1) dans la couche de la couche d'encapsulation (2), le procédé comprenant, préalablement à l'étape de report de la puce LED (1) dans la couche de la couche d'encapsulation (2), une étape de fixation de la puce LED (1) sur un support (10) plan ou convexe.
